# EUROPEAN PATENT APPLICATION

(11) **EP 2 955 253 A1**
(43) Date of publication of application: **16.12.2015**
(21) Application number: 14749478.5
(22) Date of filing: 06.02.2014
(51) Int. Cl.: C30B 29/38, C30B 25/18

(54) **GAN SUBSTRATE AND METHOD FOR MANUFACTURING GAN SUBSTRATE**

(30) Priority: 08.02.2013 JP 2013022814
(71) Applicant: Namiki Seimitsu Houseki kabushikikaisha, Adachi-ku Tokyo 123-8511 (JP); Disco Corporation, Tokyo 143-8580 (JP)
(72) Inventor: AIDA Hideo, Tokyo 123-8511 (JP); AOTA Natsuko, Tokyo 123-8511 (JP); IKEJIRI Kenjiro, Tokyo 123-8511 (JP); KIM Seongwoo, Tokyo 123-8511 (JP); KOYAMA Koji, Tokyo 123-8511 (JP); TAKEDA Hidetoshi, Tokyo 123-8511 (JP); UEKI, Atsushi, Tokyo 143-8580 (JP)
(74) Representative: Prinz & Partner mbB
(86) International application number: PCT/JP2014/052713
(87) International publication number: WO 2014/123171

(57) **Abstract**

Provided is a technology capable of simply manufacturing a GaN substrate, which is constituted by a GaN crystal having a substantially uniform dislocation density distribution, without using a complicated process, at low cost and at a high yield ratio.

An inside of a single crystal substrate is irradiated with a laser to form an amorphous portion on the inside of the single crystal substrate, and a GaN crystal is formed on a one surface of the single crystal substrate to prepare a GaN substrate. A dislocation density distribution over the entirety of a surface of the GaN substrate that is prepared is substantially uniform. The amorphous portion is provided in a plurality of linear patterns in a planar direction of the single crystal substrate, and in a case where a pitch between respective patterns is 0.5 mm, a volume ratio of a total volume of the amorphous portion to a volume of the single crystal substrate is 0.10% or 0.20%. In a case where the pitch between the respective patterns is 1.0 mm, the volume ratio of the total volume of the amorphous portion to the volume of the single crystal substrate is 0.05% or 0.10%.

## Description

### Technical Field

The present invention relates to a GaN substrate, and a method of manufacturing the GaN substrate.

### Background Art

A gallium nitride (GaN) crystal, which constitutes a light emitting diode (LED) element, is obtained through epitaxial growth on an underlying substrate by using a vapor phase growth method such as a metal-organic vapor phase epitaxy (MOVPE) and hydride vapor phase epitaxy (HVPE).

However, when using a sapphire substrate and the like as the underlying substrate, the GaN crystal is grown by a hetero-epitaxial growth method, and thus lattice constants of the underlying substrate and the GaN crystal do not match each other. Therefore, it is difficult to obtain a GaN crystal with good quality through the epitaxial growth, and a lot of crystal defects are contained in the GaN crystal. The crystal defects become a cause of hindering an improvement in element characteristics, and thus an examination has been made to reduce the crystal defects in the GaN crystal. Examples of a method of obtaining a GaN crystal in which the crystal defects are less include a selective growth method.

The selective growth method is a method in which after a thin GaN crystal is grown on the underlying substrate, the growth of the GaN crystal is stopped for the moment, patterning is performed on the underlying substrate by using a mask formed from SiO₂ and the like, and a growth portion and a non-growth portion are formed when the GaN crystal is grown again. It is possible to stop propagation of a dislocation by the mask, and it is also possible to bend the dislocation through lateral growth of the GaN crystal. Accordingly, even when the growth thickness of the GaN crystal is small, it is possible to obtain a GaN crystal in which a dislocation density is reduced. In addition, when the growth thickness of the GaN crystal becomes small, it is possible to suppress a crack occurrence frequency during the GaN crystal growth. As the selective growth method, an epitaxial lateral overgrowth (ELOG) method, a facet-controlled ELO (FACELO) method, a void-assisted separation (VAS) method, a DEEP (dislocation elimination by the epitaxial growth with inverse-pyramidal pits) method, and the like are reported (for example, with regard to the FACELO method, refers to NPL 1).

In addition, thermal expansion coefficients of the underlying substrate and the GaN crystal in the hetero-epitaxial growth method are different from each other. Accordingly, deformation occurs during cooling-down after the hetero-epitaxial growth, and bending occurs in the grown GaN crystal and the underlying substrate due to the deformation. There is a limitation to an amount of physical bending of the GaN crystal, and thus the GaN crystal is broken to pieces at a point of time at which the bending finally reaches a threshold value. In a case where an LED element and the like have a thickness of approximately several µm, the bending does not reach the threshold value. However, in a case where it is desired to manufacture a bulk GaN substrate, the bending in the thickness of the GaN crystal, which needs to be grown, greatly exceeds the threshold value. Examples of a method of counter-measuring the deformation due to the bending include a self-separation method.

The self-separation method is a method of naturally separating the GaN crystal that is epitaxially grown, and the underlying substrate. There is reported a technology of separating the underlying substrate and the GaN crystal by using a stress that occurs during cooling-down to room temperature after completion of the growth of the GaN crystal, and examples of the technology include a nano-pendeo method, and the like. For separation, it is necessary to prepare a physically weak portion to which a stress tends to operate during cooling-down. In the nano-pendeo method, nano-patterning and etching are performed with respect to GaN thin film crystal at an initial period of epitaxial growth to form, for example, a needle with a nano-scale, and then a GaN crystal that is a bulk body is grown again on the needle. A gap corresponding to the height of the needle is left between the underlying substrate and the GaN crystal during re-growth of the GaN crystal. Accordingly, when a stress is applied, the needle is broken, and thus it is possible to separate the underlying substrate and the GaN crystal from each other (for example, with regard to the self-separation method by using the needle, refer to PTL 1).

### Citation List

### Non-Patent Literature

[NPL 1] Yoshiaki HONDA, Transmission Electron Microscopy Investigation of Dislocations in GaN Layer Grown by Facet-Controlled Epitaxial Lateral Overgrowth, (2001)

### Patent Literature

[PTL 1] Published Japanese Translation No. 2009-522822 of the PCT International Publication

### Summary of Invention

### Technical Problem

However, the GaN crystal obtained by the selective growth method has a problem in that a dislocation density distribution is not uniform. During growth of the GaN crystal, propagation of the dislocation is stopped by the mask, or the dislocation is bent or concentrated to a specific portion, and thus a low dislocation density distribution is not uniform on the entire surface of the GaN crystal, and is locally concentrated, thereby leading to non-uniformity. In a process of preparing a device that uses the GaN substrate that is constituted by the GaN crystal, only a specific portion of the GaN substrate can be used, and thus it is difficult to use the entire surface of the GaN substrate. Accordingly, a usable range of the entirety of the GaN substrate is reduced. In addition, it is necessary to stop the growth of the GaN crystal for the moment, and to perform patterning of the mask through photolithography and the like. As a result, it can be said that the selective growth method is a cost requiring method.

In addition, even in the self-separation method, a technology such as nano-implantation is necessary to prepare the needle in a nano-scale, and thus cost is required. In addition, the mask for nana-patterning is necessary, and thus the nano-implantation technology is necessary to prepare the mask. Accordingly, a manufacturing process becomes complicated, and requires considerable cost.

In addition, it cannot be said that the self-separation method can reliably accomplish the separation in a probability of 100%. It is necessary for the nano-patterning and the like to be uniformly performed with respect to the entire surface of the underlying substrate, but in the photolithography patterning technology, a great pattern loss occur. In a pattern loss portion, stress application for self-separation does not operate, and thus a crack may occur from the pattern loss portion as a starting point. Accordingly, a yield ratio is reduced.

As described above, in the related art, there are problems such as non-uniformity in a dislocation density distribution, complication of a process of manufacturing a GaN crystal or GaN substrate, high cost, and a reduction in a yield ratio.

The invention has been made in consideration of the above-described circumstances, and an object thereof is to provide a technology capable of simply manufacturing a GaN substrate, which is constituted by a GaN crystal having a substantially uniform dislocation density distribution, without using a complicated process at low cost and at a high yield ratio.

### Solution to Problem

The above-described object is accomplished by the following invention.
(1) According to an aspect of the invention, there is provided a GaN substrate that is constituted by a GaN crystal. A dislocation density distribution over the entirety of a surface of the GaN substrate is substantially uniform.
(2) According to another aspect of the invention, there is provided a method of manufacturing a GaN substrate. The method includes irradiating an inside of a single crystal substrate with a laser to form an amorphous portion on the inside of the single crystal substrate, and then forming a GaN crystal on a one surface of the single crystal substrate to prepare the GaN substrate.
(3) According to an embodiment of the method of manufacturing a GaN substrate of the invention, it is preferable that the amorphous portion is provided in a plurality of linear patterns in a planar direction of the single crystal substrate, a pitch between respective patterns is 0.5 mm, and a volume ratio of a total volume of the amorphous portion to a volume of the single crystal substrate is 0.10% or 0.20%.
(4) According to another embodiment of the method of manufacturing a GaN substrate of the invention, it is preferable that the amorphous portion is provided in a plurality of linear patterns in a planar direction of the single crystal substrate, a pitch between respective patterns is 1.0 mm, and a volume ratio of a total volume of the amorphous portion to a volume of the single crystal substrate is 0.05% or 0.10%.

### Advantageous Effects of Invention

According to an aspect (that is, invention described in (1)), in any thickness, a localized dislocation density distribution on a surface of the GaN substrate is prevented in each thickness, and thus it is possible to obtain a substantially uniform dislocation density on the surface of the GaN substrate 1. Accordingly, in a process of preparing an element or a device which uses the GaN substrate, it is possible to prepare the element or device at any site on the surface of the GaN substrate, and thus it is possible to use the entirety of the surface of the GaN substrate.

In addition, according to the another aspect (that is, invention described in (2)), it is possible to make the dislocation density distribution of the GaN crystal substantially uniform without using a mask and the like on a GaN crystal growth plane of an underlying substrate, and thus a manufacturing process can be simplified, and a reduction in cost can be accomplished. In addition, cracking to the GaN crystal is prevented from occurring, and thus it is possible to manufacture the GaN crystal with high yield ratio.

In addition, according to the embodiment of the method of manufacturing a GaN substrate (that is, invention described in (3) or (4)), in addition to the effect of the another aspect of the invention, it is possible to make the dislocation density distribution of the GaN crystal substantially more uniform.

### Brief Description of Drawings

FIG. 1 is a perspective view illustrating an example of a GaN substrate according to this embodiment.
FIG. 2 is an example of a CL image illustrating a dislocation distribution on a surface of the GaN substrate according to this embodiment.
FIG. 3 is another example of the CL image illustrating the dislocation distribution on the surface of the GaN substrate according to this embodiment.
FIG. 4 is a schematic view illustrating an example of a laser irradiation process with respect to a single crystal substrate of this embodiment.
FIG. 5 is a schematic view illustrating another example of the laser irradiation process with respect to the single crystal substrate of this embodiment in which an amorphous portion is formed in a half region on a one surface side in a thickness direction.
FIG. 6 is a schematic view illustrating another example of the laser irradiation process with respect to the single crystal substrate of this embodiment in which the amorphous portion is formed in the central region in the thickness direction.
FIG. 7 is a schematic view illustrating still another example of the laser irradiation process with respect to the single crystal substrate of this embodiment in which a total of two layers of the amorphous portions are formed, each layer being formed in an upper half region and in a lower half region in the thickness direction, respectively.

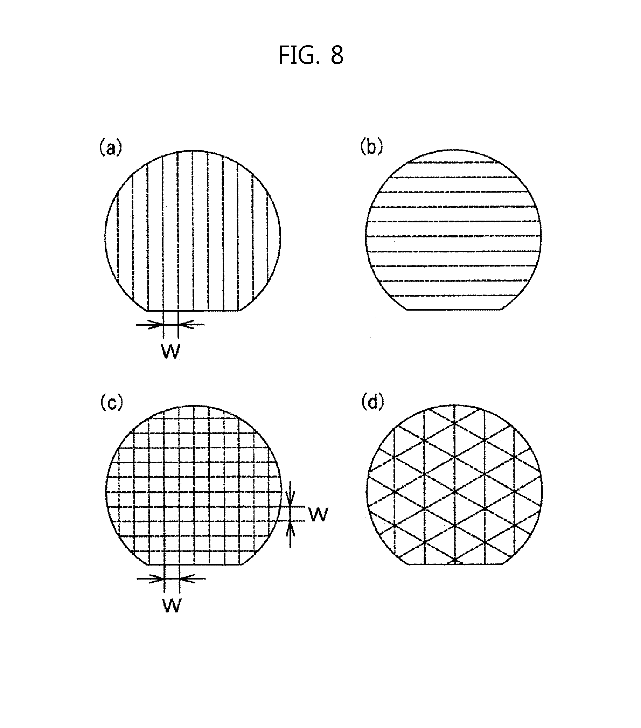

FIG. 8A to FIG. 8D are a plan view illustrating an example of an arrangement pattern shape of the amorphous portion with respect to a planar direction of the single crystal substrate. Here, FIG. 8A is a plan view illustrating a stripe shape in which a plurality of linear patterns are formed to be perpendicular to an orientation flat surface of the single crystal substrate, FIG. 8B is a plan view illustrating a stripe shape in which the plurality of linear patterns are formed to be parallel with the orientation flat surface of the single crystal substrate, FIG. 8C is a plan view illustrating a lattice shape which is formed by combining the patterns illustrated in FIG. 8A and FIG. 8B, and FIG. 8D is a plan view illustrating a shape in which a plurality of regular hexagons having the same size are regularly arranged in such a manner that each of six vertexes of an arbitrary regular hexagon overlaps to any one vertex of a regular hexagon that is adjacent to the arbitrary regular hexagon.
FIG. 9 is a view schematically illustrating an epitaxial growth process of a GaN crystal. Here, (a) of FIG. 9 is a view illustrating a state before initiation of growth, (b) of FIG. 9 is a view illustrating a state in which a low-temperature buffer layer is formed, and (c) of FIG. 9 is a view illustrating a state in which the GaN crystal is formed.
FIG. 10 is a photograph of external appearance of a GaN substrate according to an example of the invention.
FIG. 11 is a photograph of a GaN crystal according to a comparative example.

### Description of Embodiments

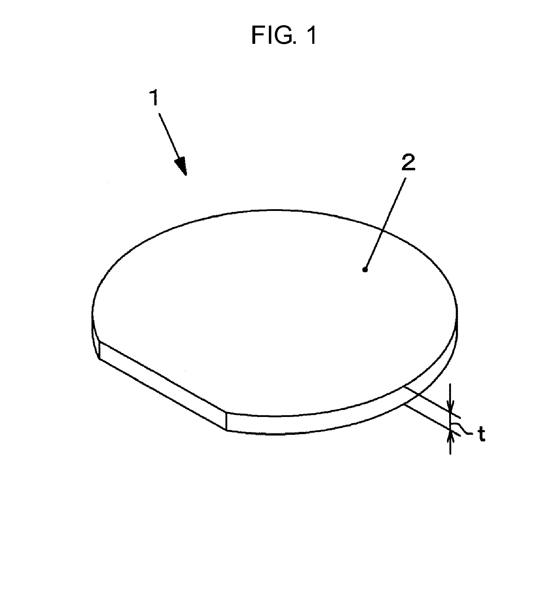

Hereinafter, a gallium nitride (GaN) substrate according to the invention will be described in detail with reference to FIG. 1 to FIG. 3. A shape of the GaN substrate according to the invention in a planar direction is not particularly limited, and may be, for example, a rectangular shape. However, a circular shape is preferable from the viewpoint of ease of use, for example, in a process of manufacturing various elements such as an LED element that is known, and a circular shape, in which an orientation flat surface is formed as illustrated in FIG. 1, is more preferable.

In a case where the shape of the GaN substrate 1 is the circular shape or the circular shape in which the orientation flat surface is formed, the diameter of the GaN substrate 1 is preferably 50 mm or greater from the viewpoint of an increase in size, more preferably 75 mm or greater, and still more preferably 150 mm or greater. In addition, the upper limit of the diameter is not particularly limited, but is preferably 300 mm or less from the viewpoint of practical use.

Accordingly, a surface 2 of the GaN substrate 1 has a surface area of at least 2 cm². In addition, more preferably, the surface 2 has a surface area greater than 15 cm² from the viewpoint of an increase in size.

In addition, the thickness t of the GaN substrate 1 may be arbitrarily set. However, the thickness t is preferably 5.0 mm or less, more preferably 3.0 mm or less, and still more preferably 2.0 mm or less. The lower limit of the thickness t is not particularly limited. However, the lower limit is preferably 0.05 mm or greater from the viewpoint of securing rigidity of the GaN substrate 1, and more preferably 0.1 mm or greater.

The GaN substrate 1 is constituted by a gallium nitride (GaN) crystal, and a GaN single crystal is more preferable. In addition, it is assumed that a crack does not exist.

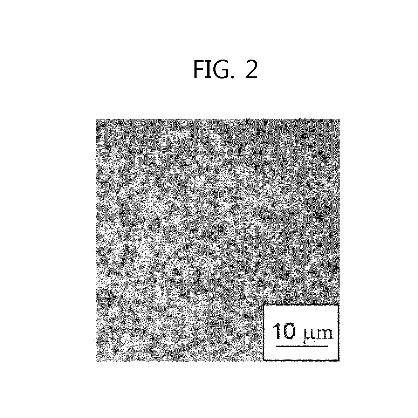

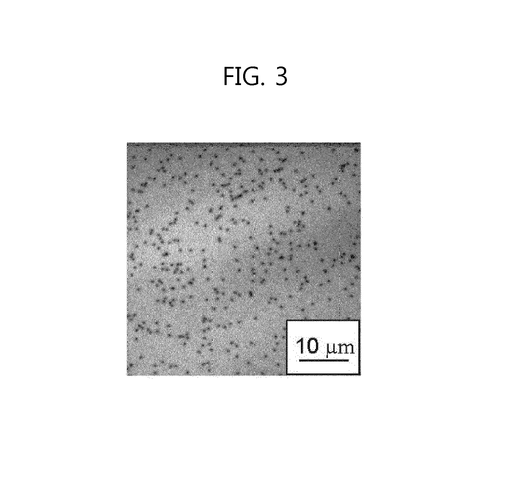

On the other hand, as illustrated in FIG. 2 and FIG. 3, in the GaN substrate according to the invention, occurrence of a dislocation is permitted over the entirety of a surface of the substrate. However, a dislocation density distribution over the entirety of the surface of the GaN substrate is substantially uniform.

Here, in the invention, the "dislocation density" represents the number of dislocation lines which reach the surface 2 of the GaN substrate 1 per unit area of the surface 2. The dislocation lines cannot be determined with the naked eye, but can be detected through measurement by using a transmission electron microscope (TEM), an atomic force microscope (AFM), or a cathode luminescence (CL) image. Alternatively, the surface 2 of the GaN substrate 1 is immersed in a heated mixed solution of phosphoric acid and sulfuric acid to allow an etch pit corresponding to a dislocation to occur. A distribution of the etch pit may be measured by using the TEM, the AFM, or the CL image to detect the dislocation.

In addition, in the invention, the expression of "substantially uniform" represents that a dislocation density distribution occurs over the entirety of the surface 2 of the GaN substrate 1, and dislocations are randomly and uniformly distributed on the surface 2, and thus even when measuring the dislocation density distribution per 1 cm² at an any site on the surface 2, the dislocation density distribution enters a constant numerical value range. Accordingly, in the invention, the expression of "substantially uniform" does not represent that the dislocation density distribution is completely constant without depending a position on the surface 2 of the GaN substrate 1, but represents that even when measuring the dislocation density distribution per 1 cm² at any site on the surface 2, the dislocation density distribution enters a constant numerical value range. Here, the constant numerical value range is determined in accordance with an element or a device which is to be manufactured, and a manufacturing process thereof, and thus the constant numerical value range is not determined in the same way.

An absolute value of the dislocation density of the GaN substrate 1 is preferably as low as possible. However, the upper limit is different depending on an element or a device which is to be manufactured, and thus cannot be determined in the same way. For example, in a case of a light-emitting element, as an emission wavelength of a target light-emitting element becomes shorter, a GaN substrate with a lower dislocation density is demanded. In addition, a substrate with a lower dislocation density is demanded for a laser diode (LD) in comparison to an LED element.

As described above, according to the GaN substrate 1 of the invention, in any thickness, a localized dislocation density distribution on the surface 2 of the GaN substrate 1 is prevented in each thickness t, and thus it is possible to obtain a substantially uniform dislocation density on the surface 2 of the GaN substrate 1. Accordingly, in a process of preparing an element or a device which uses the GaN substrate 1, it is possible to prepare the element or device at any site on the surface 2 of the GaN substrate 1, and thus it is possible to use the entirety of the surface 2 of the GaN substrate 1.

In addition, at an initial stage of GaN substrate growth that is performed by using an underlying substrate that is constituted by a crystal different from that of the GaN substrate 1, a lot of dislocations occur at a hetero-epitaxial growth interface of the underlying substrate and the GaN substrate. Accordingly, in a case where the thickness t of the GaN substrate 1 is 50 µm (0.05 mm), it is preferable that the dislocation density per 1 cm² on the surface 2 of the GaN substrate 1 is 3.0×10⁷ or more and 5.0×10⁷ or less.

In addition, when epitaxial growth of the GaN substrate progresses, and the GaN substrate 1 is formed in a large thickness, a self-standing GaN substrate is obtained. Here, the expression of "substrate capable of self-standing" or "self-standing substrate" in the invention represents a substrate which is capable of retaining its own shape and has strength to a certain extent in which a problem does not occur during handling. In order to have the strength, it is preferable that the thickness of the substrate is set to 0.2 mm or greater. In addition, it is preferable that the upper limit of the thickness of the self-standing substrate is set to 1 mm or less in consideration of ease of cleavage after forming an element or a device.

When the epitaxial growth of the GaN substrate progresses to a certain extent in which the self-standing substrate is obtained, along with the progress of the epitaxial growth, collision between dislocations naturally occurs, and thus the dislocations which collide with each other disappear. Accordingly, when the thickness t of the GaN substrate 1 is formed to a certain extent in which the self-standing substrate is obtained, a dislocation density that is measured further decreases in comparison to the initial stage. Accordingly, in a case where the thickness t of the GaN substrate 1 is 200 µm (0.2 mm), it is preferable that the dislocation density per 1 cm² on the surface 2 of the GaN substrate 1 is 0.9×10⁷ or more and 1.5×10⁷ or less.

As described above, in a case where the thickness t is 50 µm (0.05 mm), the dislocation density per 1 cm² on the surface 2 becomes 3.0×10⁷ or more and 5.0×10⁷ or less. Accordingly, a variation in the dislocation density at t=50 µm becomes approximately 167% in terms of the percentage. On the other hand, in a case where the thickness t is 200 µm (0.2 mm), the dislocation density per 1 cm² on the surface 2 becomes 0.9×10⁷ or more and 1.5×10⁷ or less. A variation in the dislocation density at t=200 µm becomes approximately 167% in terms of the percentage, and thus it can be seen that this variation falls in a constant numerical value range along with the variation in the dislocation density at t=50 µm. As described above, according to the GaN substrate 1 of the invention, in any thickness, it is possible to obtain a substantially uniform dislocation density on the surface 2.

It is necessary for a conduction type of the GaN substrate 1 to be appropriately controlled in accordance with a target element or device, and the conduction type cannot be determined in the same way. Examples of the conduction type that is applicable to an element or a device include an n-type that is doped with Si, S, O, or the like, a p-type that is doped with Mg, Zn, or the like, or a semi-insulating type which is doped with In-GaN, Fe, Cr, or the like, or which is doped with a n-type dopant and a p-type dopant in combination with each other. In addition, it is also necessary for an absolute value of a carrier concentration in the GaN substrate 1 to be appropriately controlled in accordance with a target element or device, and thus the absolute value cannot be determined in the same way.

A front surface of the GaN substrate 1 is subjected to lapping, polishing, and CMP processing. On the other hand, a rear surface of the GaN substrate 1 is subjected to lapping and/or polishing. The lapping and polishing with respect to the front surface are mainly performed to obtain a flat substrate shape, and the lapping with respect to the rear surface is mainly performed to obtain a desired thickness t. The front surface becomes the surface 2, and has a substantially uniform dislocation density distribution. Accordingly, the rear surface may have a dislocation density higher than that of the front surface, and the dislocation density distribution may not be substantially uniform on the rear surface. In addition, it is preferable that the surface 2 is a flat mirror surface, and that surface roughness Ra of the surface 2 is a degree at which an element or device can be formed, and thus it is preferable that the surface roughness Ra is 0.1 nm or less.

In addition, it is preferable that the front surface of the GaN substrate 1 is a group III plane of (0001). The reason for the preference is that a GaN-based crystal has strong polarity, and the group III plane is chemically and thermally more stable in comparison to a group V plane (nitrogen plane), and thus manufacturing of an element or a device becomes easier on the group III plane.

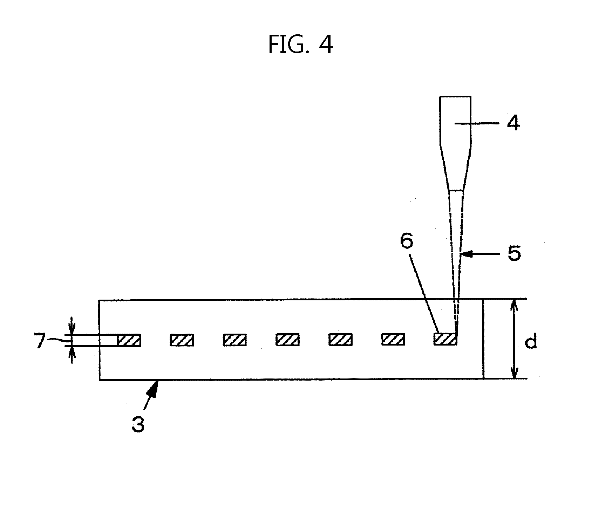

Next, a method of manufacturing a gallium nitride (GaN) substrate according to the invention will be described in detail with reference to FIG. 4 to FIG. 6. First, a single crystal substrate is prepared as an underlying substrate for epitaxial growth which is used to manufacture the GaN substrate according to the invention. As a material of the underlying substrate, any single crystal material that is known may be used as long as an amorphous portion can be formed through irradiation of a laser, and examples thereof include sapphire, a nitride semiconductor, Si, GaAs, crystallized quartz, SiC, and the like. In a case of employing the following irradiation conditions A, particularly, Si, GaAs, crystallized quartz, or SiC can be appropriately used. In addition, crystalized quartz, glass, and the like may be used instead of the single crystal substrate.

Among these, particularly, a sapphire single crystal substrate is more preferable because the sapphire single crystal is stable even in a high-temperature region of equal to or higher than 1000°C that is a growth temperature of a GaN crystal, and does not react with a raw material gas for the GaN crystal growth, or H₂, NH₃, and HCl which are atmosphere gases.

In addition, as the single crystal substrate, a single crystal substrate of which at least a one surface is mirror-polished is used. In this case, the GaN substrate is grown and formed on the mirror-polished surface in the following epitaxial growth process. In addition, as necessary, a single crystal substrate of which both surfaces are mirror-polished may be used, and any one surface thereof may be used as a growth surface of the GaN substrate. The polishing may be performed in such a manner that the one surface for crystal growth becomes smooth to a certain extent in which the epitaxial growth is possible, and as a guide, the surface roughness Ra is preferably 0.1 nm or less. In addition, it is assumed that a crack does not exist.

In addition, in a case of using the sapphire substrate as the single crystal substrate, as a crystal growth plane of the GaN substrate, a C-plane is preferable. However, a plane such as an R-plane, an M-plane, and an A-plane other than the C-plane can be used without limitation to the C-plane.

A shape of the single crystal substrate in a planar direction is not particularly limited, and may be a rectangular shape, and the like. However, a circular shape is preferable from the viewpoint of ease of use, for example, in a process of manufacturing various elements such as an LED element that is known, and a circular shape, in which an orientation flat surface is formed, is more preferable.

In a case where the shape of the single crystal substrate is the circular shape or the circular shape in which the orientation flat surface is formed, the diameter of the single crystal substrate is preferably 50 mm or greater from the viewpoint of an increase in size, more preferably 75 mm or greater, and still more preferably 150 mm or greater. In addition, the upper limit of the diameter is not particularly limited, but is preferably 300 mm or less from the viewpoint of practical use.

Accordingly, a surface of the single crystal substrate has a surface area of at least 2 cm². In addition, more preferably, the surface has a surface area greater than 15 cm² from the viewpoint of an increase in size.

In addition, the thickness of the single crystal substrate is preferably 5.0 mm or less, more preferably 3.0 mm or less, and still more preferably 2.0 mm or less. The lower limit of the thickness is not particularly limited. However, the lower limit is preferably 0.05 mm or greater from the viewpoint of securing rigidity of the single crystal substrate, and more preferably 0.1 mm or greater. In addition, in a case where the single crystal substrate has the circular shape or the circular shape in which the orientation flat surface is formed, when the diameter is 50 mm or more and 150 mm or less, the thickness is preferably 0.3 mm or greater, and when the diameter is greater than 150 mm, the thickness is preferably 0.5 mm or greater.

In addition, as the manufacturing method, a method, in which a GaN substrate 1 that is constituted by a GaN crystal is used as the underlying substrate, and an additional GaN crystal is grown on a one surface of the underlying substrate, can be exemplified. In this case, in theory, a problem regarding to the bending does not occur during cooling-down after GaN crystal growth, but actually, a considerable difference in crystal characteristics may occur between the underlying substrate and the GaN crystal that is formed through growth, and a bending actually occurs. Accordingly, the method of manufacturing a GaN substrate according to the invention is applied to not only a case of using a different kind of substrate as the underlying substrate, but also a case of using the GaN substrate as the underlying substrate.

The method of manufacturing a GaN substrate of the invention includes a single crystal substrate and GaN substrate which is formed of an amorphous portion and a GaN crystal, the amorphous portion being formed on an inside of a thickness direction of the single crystal substrate through laser irradiation with respect to the single crystal substrate and the GaN crystal being formed on one surface of the single crystal substrate. In addition, in a case of using a single crystal substrate in which the one surface serving as the growth surface is a polished surface, it is more preferable that the laser irradiation with respect to the single crystal substrate is performed through the polished surface. In addition, in a case of performing laser irradiation, it is more preferable that a surface of the single crystal substrate on a laser irradiation side is in a mirror surface state. To make a surface irradiated with a laser to become a mirror surface state, for example, mirror polishing can be implemented.

In addition, the "amorphous" in the invention is defined as a portion that is non-crystalline and does not have a complete crystal structure. In addition, the "amorphous portion" represents a part of the single crystal substrate which is amorphous and is formed by locally heating a partial region on an inside of the single crystal substrate in a thickness direction.

As a method of forming the amorphous portion, as illustrated in FIG. 4, a method of irradiating the single crystal substrate 3 with a laser 5 emitted from a laser irradiation apparatus 4 is used. In this case, due to multi-photon absorption of atoms which exist in a laser irradiated region, the region is locally heated, and slight modification such as a variation in a crystal structure or crystallinity in comparison to a peripheral region occur, and thus an amorphous portion 6 is formed. That is, the GaN substrate 1 according to the invention is manufactured after being subjected to at least a process of forming the amorphous portion 6 on an inside of a thickness direction of the single crystal substrate 3 through laser irradiation with respect to the single crystal substrate 3.

### - Laser Irradiation Conditions -

In addition, the laser irradiation may be implemented under arbitrary irradiation conditions as long as the amorphous portion 6 can be formed on an inside of the single crystal substrate 3, but it is preferable to implement the laser irradiation in ranges illustrated in the following items 1) and 2) by using a pulse laser that intermittently emits laser light when considering that energy can be concentrated in a short duration and thus a high peak output can be obtained.
1) Laser wavelength: 200 nm to 5000 nm
2) Pulse width: femtosecond order to nanosecond order (1 fs to 1000 ns)

Here, the laser wavelength or the pulse width is appropriately selected in consideration of light transmitting properties/light absorbing properties which are caused by a material of the single crystal substrate 3 that is a laser irradiation target, size and pattern accuracy of the amorphous portion 6 that is formed on an inside of the single crystal substrate 3, a laser apparatus that can be utilized in practical use, and the like. However, in the laser irradiation, it is preferable to select irradiation conditions illustrated in the following items A and B.

### <Irradiation Conditions A>

- Laser wavelength: 200 nm to 400 nm
- Pulse width: nanosecond order (1 ns to 1000 ns). In addition, more preferably 10 ns to 15 ns.

### <Irradiation conditions B>

- Laser wavelength: 400 nm to 2000 nm
- Pulse width: femtosecond order to picosecond order (1 fs to 1000 ps). In addition, more preferably 200 fs to 800 fs.

In addition, when comparing the irradiation conditions A and B, a laser in which a laser wavelength is in a shorter-wavelength region is used under the irradiation conditions A. Accordingly, in a case of implementing laser irradiation in a state in which conditions other than the laser wavelength and the pulse width are set to be the same as each other, under the irradiation conditions A, it is possible to further shorten a laser processing time in comparison to the irradiation conditions B. In addition, as the wavelength of the laser that is used, it is preferable to select a wavelength in a longer-wavelength region in comparison to an absorption edge wavelength of the single crystal substrate 3 that becomes a laser irradiation target.

Here, in a case where the single crystal substrate 3 is a Si substrate, the above-described irradiation conditions B can be used. In this case, it is preferable that conditions other than the laser wavelength are selected in the following ranges, for example, from the viewpoint of practicability, mass productivity, and the like.
- Pulse width: 50 ns to 200 ns
- Repetition frequency: 10 kHz to 500 kHz
- Irradiation energy: 3 µJ to 30 µJ
- Spot size of laser: 0.5 µm to 4.0 µm
- Scanning velocity of a sample stage: 50 mm/s to 1000 mm/s (more preferably, 100 mm/s to 1000 mm/s)

The laser irradiation with respect to the single crystal substrate 3 is implemented in a state in which the single crystal substrate 3 is fixed to a sample stage (not illustrate). In addition, it is preferable that the fixing is implemented, for example, through vacuum suction and the like so as to correct of the bending of the single crystal substrate 3. In addition, a mirror surface of the single crystal substrate 3 which is fixed to the sample stage, is irradiated with the laser 5 by using the laser irradiation apparatus 4. At this time, the laser 5 is condensed to an inside of the thickness d direction of the single crystal substrate 3, and the laser irradiation apparatus 4 and the single crystal substrate 3 are relatively moved in the horizontal direction. According to this, a plurality of the amorphous portions 6 having a spot shape are formed in a continuously connected linear shape.

When viewed locally, the amorphous portion 6 having the spot shape is formed only at portions which are instantaneously irradiated with the laser 5, and the size of the amorphous portion 6 depends on a spot size of the laser 5, laser intensity, and a pulse width. When appropriately selecting the spot size of the laser 5, laser power, the pulse width, and the like, it is possible to control a size, a modified degree, and the like of the amorphous portion 6 in a planar direction or a thickness direction of the single crystal substrate 3. In addition, the length of the spot-shaped amorphous portions 6 which are formed in a linear shape may be controlled by appropriately selecting a relative moving velocity (for example, in a case where the sample stage can be moved, a scanning velocity of the sample stage) of the laser irradiation apparatus 4 with respect to the single crystal substrate 3, and the repetition frequency of the laser 5, with the intervals arranged between the plurality of amorphous portions 6 in the planar direction of the single crystal substrate 3.

When the plurality of amorphous portions 6, which are formed in a linear shape, are combined with each other, at least one kind of pattern of the amorphous portions 6, which is constituted by the amorphous portions 6, is formed at a desired position of the single crystal substrate 3 in a thickness direction.

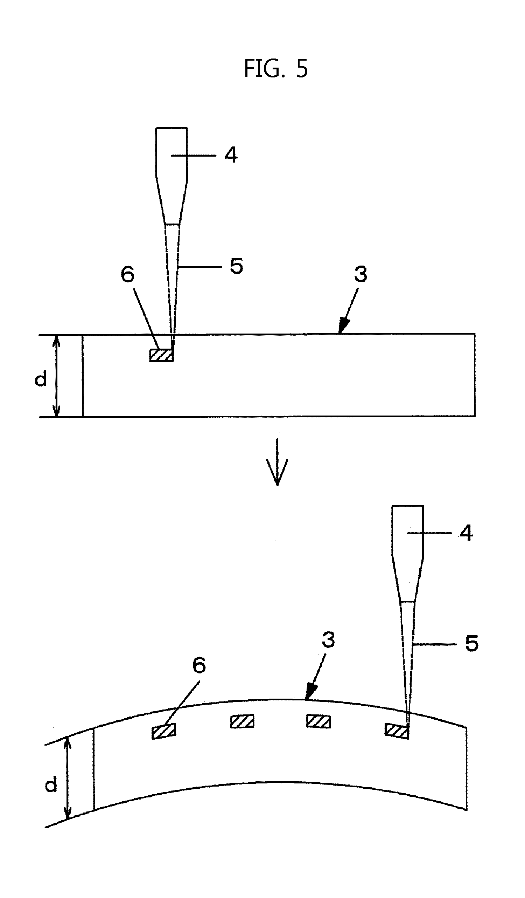

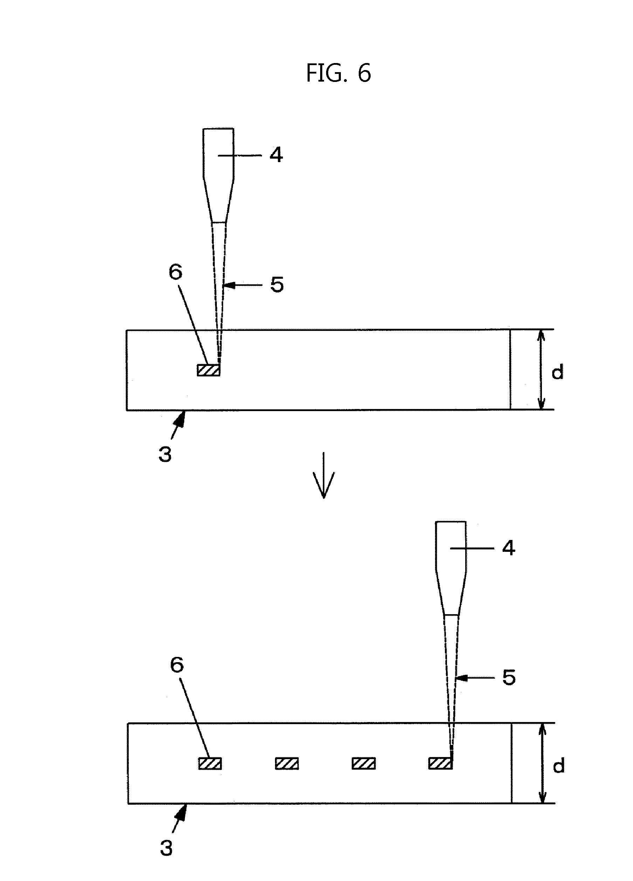

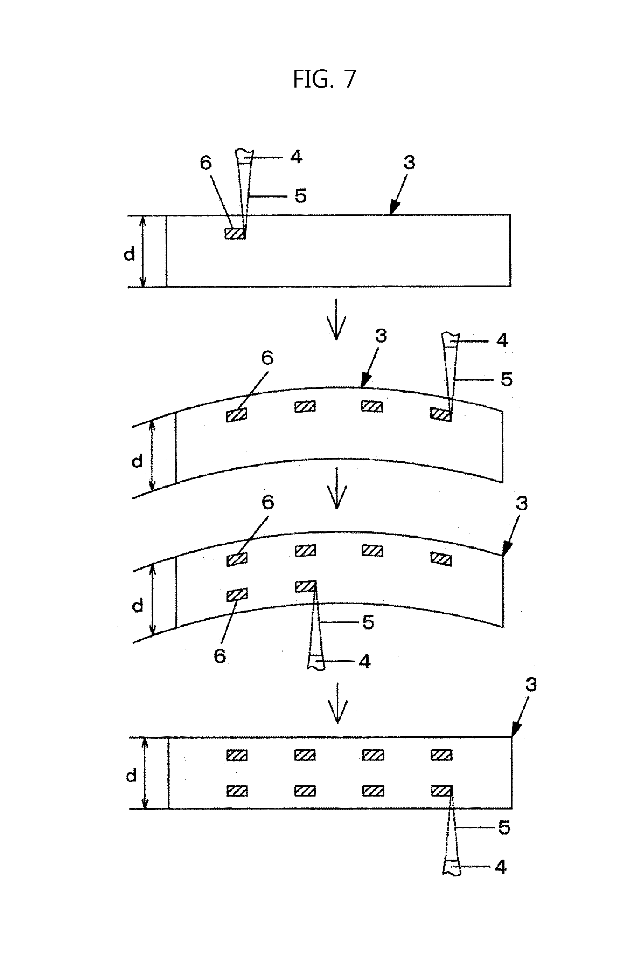

When optimizing conditions such as a pattern shape, formation positions, and the length of the amorphous portions 6, the entire stress of the single crystal substrate 3 is controlled, and thus it is possible to control a bending shape and/or an amount of a bending in the single crystal substrate with accuracy. As illustrated in FIG. 5, each of the amorphous portions 6 may be formed in a half region on a one surface side in a thickness d direction to form the bending in the single crystal substrate 3. In addition, a total of two layers of the amorphous portions 6 may be formed, each layer being formed in an upper half region and in a lower half region in the thickness d direction, respectively. According to this, for example, as illustrated in FIG. 7, a flat single crystal substrate 3 in which the bending disappears may be formed. In addition, as illustrated in FIG. 6, when the amorphous portions 6 are formed in the central region in the thickness d direction, it is possible to prevent the bending from occurring in the single crystal substrate 3 before and after formation of the amorphous portions 6.

FIG. 8 is a plan view illustrating an example of an arrangement pattern shape of the amorphous portion 6 with respect to a planar direction of the single crystal substrate 3. Specifically, FIG. 8A to FIG. 8D illustrate an example of the arrangement pattern shape of the amorphous portion 6 in a case where a planar shape of the single crystal substrate 3 is a circular shape in which an orientation flat surface is provided. As illustrated in FIG. 8A to FIG. 8D, examples of the arrangement pattern shape of the amorphous portion 6 include a strip shape (FIG. 8A and FIG. 8B) in which a plurality of linear patterns are formed to be perpendicular to or to be parallel with the orientation flat surface of the single crystal substrate 3. In addition, a width W illustrated in FIG. 8A represents a pitch between lines. In addition, examples of the arrangement pattern shape include a lattice shape as illustrated in FIG. 8C in a combination of the linear patterns illustrated in FIG. 8A and FIG. 8B, and a shape in a combination of linear patterns as illustrated in FIG. 8D in which a plurality of regular hexagons having the same size are regularly arranged in such a manner that each of six vertexes of an arbitrary regular hexagon overlaps to any one vertex of a regular hexagon that is adjacent to the arbitrary regular hexagon. The linear pattern in FIG. 8D is constituted by a linear pattern that is perpendicular to the orientation flat surface, and linear patterns which are inclined to the orientation flat surface by 30° and 150°, respectively.

It is preferable that a pitch W between a plurality of linear patterns is in a range of 50 µm to 2000 µm (0.05 mm to 2 mm), and more preferably in a range of 100 µm to 1000 µm (0.1 mm to 1 mm). When the pitch is set to 50 µm or greater, it is possible to suppress time necessary for processing from being lengthened more than necessary, and when the pitch W is set to 2000 µm or less, it is possible to more reliably correct the bending of single crystal substrate 3.

In addition, the length 7 of the amorphous portion 6 in the thickness d direction of the single crystal substrate 3 is determined depending on the spot size of the laser 5, the irradiation energy (laser power/repetition frequency), and the pulse width, and is typically in a range of several µm to several tens µm.

Next, a GaN crystal is grown and formed on a one surface of the single crystal substrate 3. A method of growing the GaN crystal is not particularly limited, and a method that is known can be used. As a growth method, a liquid-phase film forming method such as a plating method may be exemplified, but it is preferable to use a vapor-phase film forming method such as sputtering method and a chemical vapor deposition (CVD) method. In addition, it is more preferable to use a vapor-phase film forming method such as an MOVPE method, an HVPE method, and a molecular beam epitaxy (MBE) method. In addition, the epitaxial growth includes homo-epitaxial growth including the same composition, and hetero-epitaxial growth including a mixed crystal.

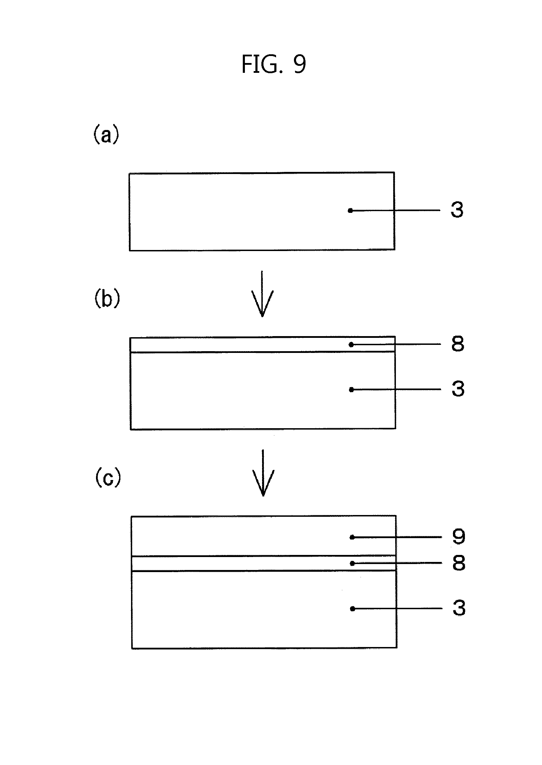

FIG. 9 is a schematic view illustrating an epitaxial growth process of the GaN crystal. As a specific example, a sapphire substrate is used as an underlying single crystal substrate 3. At first, the sapphire substrate is subjected to thermal cleaning ((a) of FIG. 9). Next, the sapphire substrate is subjected to a nitriding treatment, and then the sapphire substrate is cooled down to the vicinity of room temperature (approximately 25°C) and is exposed to the air. Next, growth of a low-temperature buffer layer 8 is performed ((b) of FIG. 9). Subsequently, a GaN crystal 9 is grown ((c) of FIG. 9). After growth of the GaN crystal 9, the single crystal substrate 3 and the GaN crystal 9 are cooled down to the vicinity of room temperature (approximately 25°C).

The GaN crystal 9 that is obtained in this manner is set as a self-standing GaN substrate 1, and is separated from the single crystal substrate 3 that is an underlying substrate. Accordingly, it is possible to obtain the GaN substrate 1 without using a complicated process such as formation of a mask. In addition, in the method of growing the GaN crystal, it is preferable to use the HVPE method in which a crystal growth rate is fast when considering the case of separating the GaN crystal from the underlying substrate after growth of the GaN crystal to obtain the self-standing GaN substrate 1.

When using the HVPE method, a growth rate of the GaN crystal, morphology, and a crystal quality may be selectively optimized by appropriately selecting a NH₃ flow rate, a HCl flow rate, and a growth temperature.

A dislocation that propagates in a growth direction during growth of the GaN crystal occurs at a high density at the bottom of the GaN crystal (in the vicinity of an interface with the single crystal substrate 3, or in the vicinity of an interface with the low-temperature buffer layer 8 in a case of FIG. 9). However, as the growth of the GaN crystal progresses, collision between dislocations naturally occurs with the progress of the growth, and thus the dislocations which collide with each other disappear. When the dislocations are accumulated, dislocations which collide with each other disappear, or form a dislocation loop, and thus the propagation of dislocation in the thickness t direction is stopped. Accordingly, it is possible to reduce a dislocation density.

Next, the single crystal substrate 3 is separated and removed from the GaN crystal 9. Separation between the GaN crystal 9 and the single crystal substrate 3 can be performed in an arbitrary manner. The removal of the single crystal substrate 3 may include exclusion of the single crystal substrate 3, removal of a part or an entirety of the single crystal substrate 3, removal of the single crystal substrate 3 in combination with the low-temperature buffer layer 8, or removal of the entirety of the single crystal substrate 3 and a part of the GaN crystal that is adjacent to the single crystal substrate 3. Examples of a separation method include mechanical grinding, chemical etching, interface decomposition, interface fracture (for example, laser lift-off, and the like), or an arbitrary method corresponding to a specific material of the single crystal substrate 3.

The laser lift-off is a method of irradiating a single crystal substrate with high-output ultraviolet laser light which has a wavelength that is transmitted through the single crystal substrate 3 but is absorbed to the GaN crystal, thereby dissolving the vicinity of an interface with the GaN crystal and separating the single crystal substrate 3. In addition to the methods, physical etching by charged beam or neutral beam may be performed.

Next, a front surface of the GaN substrate 1 is subjected to lapping, polishing, and CMP processing. On the other hand, a rear surface of the GaN substrate 1 is subjected to lapping and/or polishing. It is preferable that the surface 2 that is the front surface of the GaN substrate 1 is a flat mirror surface. The reason for the preference is as follows. A lot of large concavities and convexities such as hillock or a lot of minute concavities and convexities exist on the surface of the GaN substrate that is grown, and the concavities and convexities become a factor of causing non-uniformity in morphology, a film thickness, a composition, and the like during growth of an epitaxial layer on the surface 2. In addition, even in a process of manufacturing an element or a device, the concavities and convexities become a factor of lowering exposure accuracy in a photolithography process.

When desiring to obtain the mirror surface through a polishing process, it is necessary to scrape off the GaN crystal to a depth of several µm to several tens µm from a surface of the GaN crystal. In the invention, even after the surface layer is scraped off through polishing, it is necessary to leave a layer portion having a substantially uniform dislocation density distribution. Accordingly, in a case where the surface 2 is subjected to finish-polishing, in anticipation of a polishing margin, it is necessary to grow a layer portion, which has a substantially uniform dislocation density distribution, in advance in a constant thickness during crystal growth. Accordingly, the depth of the surface layer of the GaN crystal before the mirror polishing needs to be set to at least a depth obtained by adding the constant thickness and a mirror polishing margin.

From confirmation of the surface of the GaN substrate, which is obtained as described above, with a CL image, it can be confirmed that as illustrated in FIG. 2 or FIG. 3, a dislocation occurs over the entirety of the surface of the GaN substrate, but a dislocation density distribution is substantially uniform over the entirety of the surface. In addition, the thickness t of the GaN substrate in FIG. 2 is 50 µm, and the dislocation density per 1 cm² on the surface is 4.7×10⁷. On the other hand, the thickness t of the GaN substrate in FIG. 3 is 200 µm, and the dislocation density per 1 cm² on the surface is 1.0×10⁷.

As described above, according to the method of manufacturing the GaN substrate of the invention, it is possible to make the dislocation density distribution of the GaN crystal substantially uniform without using a mask and the like on a GaN crystal growth plane of an underlying substrate, and thus a manufacturing process can be simplified, and a reduction in cost can be accomplished.

It is possible to increase the thickness t without using the selective growth method, and thus uniform dislocation disappearance occurs with the increase in the growth thickness. Accordingly, the dislocation density distribution becomes substantially uniform. In a case where the GaN crystal is grown on the one surface of the single crystal substrate 3 in which the amorphous portion 6 is formed on an inside thereof, the principle of increasing a threshold thickness at which a crack occurs is not clear. However, the present inventors have found at first that when GaN crystal formation is performed through a process of laser irradiation into the single crystal substrate that is the underlying substrate, the thickness of the GaN crystal formed on the surface of the underlying substrate is greatly increased up to a thickness applicable to practical use, that is, a self-standing thickness.

In addition, when the amorphous portion 6 is formed in a plurality of linear patterns, the pitch W between the respective patterns is set to 0.5 mm, and a volume ratio of a total volume of the amorphous portion 6 to a volume of the single crystal substrate 3 is set to 0.10% or 0.20%, it is possible to make the dislocation density distribution of the GaN crystal substantially more uniform. The reason why the volume ratio is set to 0.10% or 0.20% is as follows. For example, 0.10% represents a volume ratio in a case of forming the amorphous portion in one layer as illustrated in FIG. 5 or FIG. 6, and 0.20% represents a volume ratio in a case of forming the amorphous portion in two layers as illustrated in FIG. 7.

In addition, in a case where the pitch W between the respective patterns is set to 1.0 mm, when the volume ratio of the total volume of the amorphous portion 6 to the volume of the single crystal substrate 3 is set to 0.05% or 0.10%, it is possible to make the dislocation density distribution of the GaN crystal substantially more uniform. The reason why the volume ratio is set to 0.05% or 0.10% is as follows. For example, 0.05% represents a volume ratio in a case of forming the amorphous portion in one layer as illustrated in FIG. 5 or FIG. 6, and 0.10% represents a volume ratio in a case of forming the amorphous portion in two layers as illustrated in FIG. 7.

### (Examples)

Hereinafter, examples of the invention will be described, but the invention is not limited to the following example.

### <<Example of Laser Irradiation>>

As an evaluation sample, a sample, in which a GaN crystal having a one-layer configuration was formed on a one surface of a sapphire single crystal substrate, was prepared in the following sequence. First, a GaN crystal non-growth surface of the sapphire single crystal substrate was irradiated with a laser to form approximately 1500 amorphous portions in the linear pattern illustrated in (d) of FIG. 8 at a pitch of 100 µm, thereby preparing a sapphire single crystal substrate having the amorphous portions. In addition, each of the amorphous portions was formed at two sites in a thickness direction of the sapphire single crystal substrate, and a length of the amorphous portion was set to 50 µm.

### - Sapphire Single Crystal Substrate -

As the sapphire single crystal substrate, a circular sapphire single crystal substrate (diameter: 2 inches (50 mm), thickness: 430 µm), in which the orientation flat surface was formed, was used. In addition, the one surface of the sapphire single crystal substrate was mirror-polished, and surface roughness Ra was set to 0.1 nm. The GaN crystal was formed by using the mirror-polished one surface as a growth surface. In addition, the one surface was set to a C-plane.

### - Conditions of Forming Amorphous Portion -

The GaN crystal non-growth surface of the single crystal substrate was subjected to mirror polishing. Next, the sapphire single crystal substrate was fixed onto a flat sample stage through vacuum suction in a state in which the surface on which the GaN crystal is to be formed was set as a lower surface side. In this state, the GaN crystal non-growth surface side of the GaN crystal was irradiated with a laser under the following conditions to form the amorphous portion. In addition, during the laser irradiation, the sapphire single crystal substrate was fixed onto the sample stage in such a manner that a scanning direction in the longitudinal direction of the sample stage matched the orientation flat of the sapphire single crystal substrate. In addition, the sample state was scanned in the longitudinal direction and the lateral direction with respect to a laser irradiation apparatus, thereby forming the amorphous portions in a linear pattern with respect to a planar direction of the sapphire single crystal substrate.
- Laser wavelength: 1048 nm
- Pulse width: 1000 fs or less
- Repetition frequency: 100 kHz
- Irradiation energy: 3 µJ
- Spot size of the laser: 4 µm
- Scanning velocity of the sample stage: 400 mm/s

### - GaN Crystal and Growth Conditions -

The GaN crystal was formed on the growth surface of the sapphire single crystal substrate in a one-layer configuration. In addition, specific growth conditions are as follows, and a process was implemented in the following sequence of (1) to (5).

### (1) Thermal Cleaning

The sapphire single crystal substrate was disposed in an HVPE apparatus, and the thermal cleaning with respect to the growth surface was implemented at a substrate temperature of 1050°C for approximately 600 seconds.

### (2) Nitriding Treatment

The nitriding treatment was implemented at a substrate temperature of 1050°C for approximately 240 seconds, and the sapphire substrate was cooled down to the vicinity of room temperature and was exposed to the air.

### (3) Formation of Low-Temperature Buffer Layer

A substrate temperature during film formation was set to 600°C, and the low-temperature buffer layer was formed until the film thickness thereof became 7 nm.

### (4) Formation of GaN Crystal

A substrate temperature during growth was set to 1045°C, and the GaN crystal was formed at a film formation rate of 30 µm/s until the thickness thereof became 200 µm.

### (5) Cooling-Down

The sapphire substrate in which the GaN crystal was formed on the one surface was cooled down to the vicinity of room temperature, and the GaN substrate was obtained from the GaN crystal. The obtained GaN substrate had a circular shape in which the orientation flat surface was formed, a diameter of 2 inches (50 mm), and a thickness of 200 µm.

### (Evaluation Result)

### - Dislocation Density and Distribution Thereof, and Evaluation of Whether or Not Crack Occur

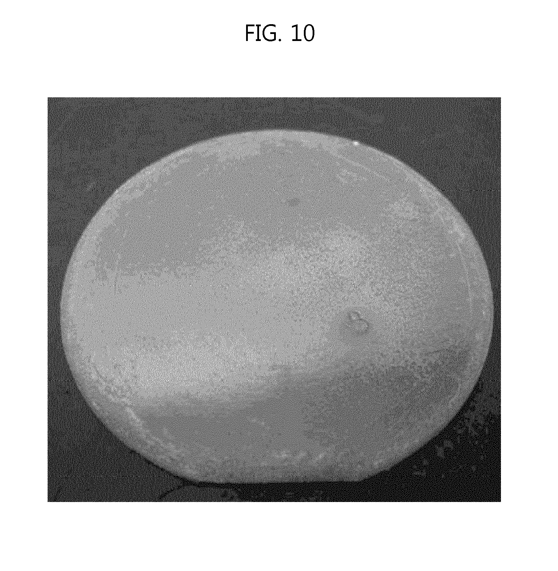

FIG. 10 illustrates a photograph of external appearance of the obtained GaN substrate. As illustrated in FIG. 10, in a case of the GaN substrate that was grown and formed by using the sapphire single crystal substrate in which the amorphous portion was formed on an inside, occurrence of a crack was not confirmed even in a thickness of 200 µm. Accordingly, it could be seen that an effect of a high yield ratio was also obtained.

In addition, the dislocation density and the dislocation distribution per 1 cm² on the surface of the GaN substrate illustrated in FIG. 10 was measured over 8 sites (two sites in the vicinity of the center of the GaN substrate, three sites in the vicinity of the peripheral edge of the GaN substrate, and three sites between the center and the peripheral edge) on the GaN substrate surface with a CL image, and from the measurement, results of 0.99×10⁷, 0.99×10⁷, 1.0×10⁷, 1.1×10⁷, 1.2×10⁷, 1.2×10⁷, 1.3×10⁷, and 1.5×10⁷ were obtained. Accordingly, it was confirmed that a reduction in the dislocation density was accomplished in a state of retaining a substantially uniform distribution together with a growth of thickness.

### (Comparative Example)

Next, a comparative example will be described. In the comparative example, the amorphous portion was not formed on the sapphire single crystal substrate, and the GaN crystal was formed on the growth surface of the sapphire single crystal substrate in a one-layer configuration. In addition, implementation conditions were set to the same as those in the example except that the amorphous portion was not formed and additionally the thickness of the GaN crystals to be grown and formed, was changed to 10 µm to 20 µm.

### (Evaluation Result)

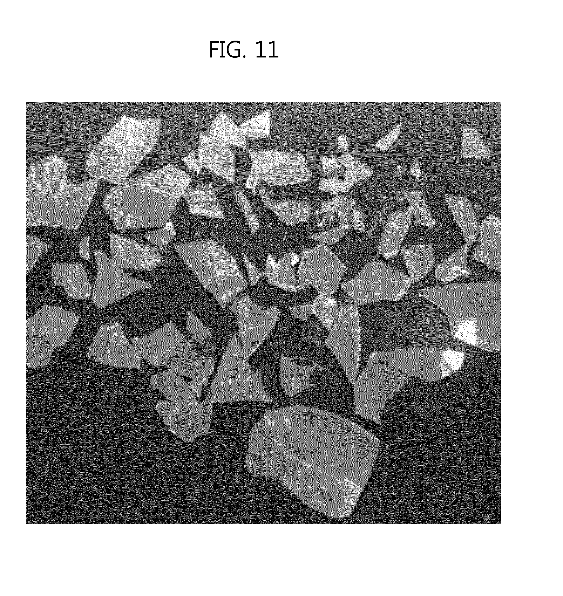

FIG. 11 illustrates a photograph of a GaN crystal according to a comparative example. As illustrated in FIG. 11, in a case of growing the GaN crystal on the sapphire substrate in which the amorphous portion was not formed, at a thickness of 10 µm to 20 µm, the GaN crystal was broken to pieces due to deformation that occurred during cooling-down.

### Reference Signs List

- 1:: GaN substrate
- 2:: Surface of GaN substrate
- 3:: Single crystal substrate
- 4:: Laser irradiation apparatus
- 5:: Laser
- 6:: Amorphous portion
- 7:: Length of amorphous portion
- 8:: Low-temperature buffer layer
- 9:: GaN crystal
- t:: Thickness of GaN substrate
- d:: Thickness of single crystal substrate

## Claims

1. A GaN substrate that is constituted by a GaN crystal,
wherein a dislocation density distribution over an entirety of a surface of the GaN substrate is substantially uniform.

2. A method of manufacturing a GaN substrate, comprising:
irradiating an inside of a single crystal substrate with a laser to form an amorphous portion on the inside of the single crystal substrate; and
then forming a GaN crystal on a one surface of the single crystal substrate to prepare the GaN substrate.

3. The method of manufacturing a GaN substrate according to claim 2,
wherein the amorphous portion is formed in a plurality of linear patterns in a planar direction of the single crystal substrate,
a pitch between respective patterns is 0.5 mm, and
a volume ratio of a total volume of the amorphous portion to a volume of the single crystal substrate is 0.10% or 0.20%.

4. The method of manufacturing a GaN substrate according to claim 2,
wherein the amorphous portion is provided in a plurality of linear patterns in a planar direction of the single crystal substrate,
a pitch between respective patterns is 1.0 mm, and
a volume ratio of a total volume of the amorphous portion to a volume of the single crystal substrate is 0.05% or 0.10%.
